Europäisches Patentamt

European Patent Office

Office européen des brevets

(11) Numéro de publication: **0 215 691 B1**

# FASCICULE DE BREVET EUROPEEN

(45) Date de publication de fascicule du brevet: **14.04.93**

(51) Int. Cl.5: **C30B 9/00**, C30B 29/14

(21) Numéro de dépôt: **86401670.4**

(22) Date de dépôt: **25.07.86**

(54) **Procédé de synthèse en flux de cristaux du type du KTiOP04 ou monophosphate de potassium et de titanyle.**

(30) Priorité: **26.07.85 FR 8511520**

(43) Date de publication de la demande:
**25.03.87 Bulletin 87/13**

(45) Mention de la délivrance du brevet:
**14.04.93 Bulletin 93/15**

(84) Etats contractants désignés:
**AT BE CH DE FR GB IT LI LU NL SE**

(56) Documents cités:
**EP-A- 0 004 974**

**JOURNAL OF CRYSTAL GROWTH, vol. 70, no. 1/2, décembre 1984, North Holland Physics Publishing Division, Amsterdam (NL); J.C.JACCO et al.: "Flux growth and properties of KTiOPO4", pages 484-488**

(73) Titulaire: **CENTRE NATIONAL DE LA RECHER-CHE SCIENTIFIOUE (CNRS)
15, Ouai Anatole France
F-75700 Paris Cedex 07(FR)**

(72) Inventeur: **Marnier, Gérard
31 avenue de la Malgrange
F-54140 Jarville(FR)**

(74) Mandataire: **Peaucelle, Chantal et al
Cabinet Armengaud Aine 3, avenue Bugeaud
F-75116 Paris (FR)**

## Description

L'invention a pour objet un procédé de synthèse en flux de cristaux du type du KTiOPO4 ou monophosphate de potassium et de titanyle.

Le monophosphate de potassium et de titanyle KTiOPO4, appelé plus communément KTP, a été obtenu par Masse, en 1970, par la méthode des flux, à partir de TiO2, K2CO3 et (NH4)2 HPO4, en se plaçant sur la ligne KTP-KPO3 du diagramme K2O,TiO2,P2O5. (voir Bull..Soc. Fr.Mineral Cristal (1971),vol. 94, No 4, p. 437 à 439).

L'étude ultérieure de ce composé a montré qu'il possède des propriétés d'optique non linéaire ce qui lui confère un grand intérêt, notamment, comme doubleur de fréquence. On conçoit aisément, pour les applications en optique, l'intérêt de disposer de cristaux de bonne qualité, transparents, sans cassure.

Or, les méthodes de flux proposées à ce jour pour leur obtention ne permettent pas d'obtenir des cristaux de qualité satisfaisante en raison, notamment, de leur tendance à former des verres. Les cristaux formés sont généralement opalescents et présentent un faciès de redissolution. Actuellement seule la synthèse par croissance hydrothermale, selon les brevets US 3 949 323 et EP 0 22 193, permet d'obtenir des cristaux centimétriques. Cependant leur mise en oeuvre est difficile à l'échelle industrielle compte-tenu, notamment, des pressions (de l'ordre de 3000 bars) et des températures élevées (de l'ordre de 650°C) utilisées.

Dans le brevet EP 04974, on décrit un procédé de croissance en flux concernant uniquement le diagramme ternaire K2O ou Rb2O, TiO2,P2O5 et excluant la ligne KTP-KPO3.

D'autres auteurs comme Jacco et al dans Journal of Crystal Growth 70 (1984), 484-488 ont publié un procédé de synthèse de cristaux de KTP par la méthode des flux en se plaçant dans le diagramme pseudobinaire KTP-K6P4O13 et en utilisant un flux modifié par adjonction d'additifs. Ces auteurs considèrent que seuls les flux additionnés de PbF2 conviennent mais que l'introduction non négligeable de plomb dans KTP peut être dommageable pour les propriétés optiques.

L'étude de Jacco et al concernant la solubilité de KTP dans K6P4O13 en fonction de la température confirme des travaux des inventeurs montrant que KTP cristallise seul dans un domaine compris entre les lignes KTP-K4P2O7 et KTP-K2P2O6, cette dernière ligne étant exclue étant donné que deux phases cristallisées KTP et KTi2(PO4)3 y sont obtenues.

Les recherches effectuées à ce jour confirment que les cristaux obtenus dans le diagramme K2O, P2O5, TiO2 sont difficiles à obtenir en raison de leur forte tendance à former des verres et du fait de la variation brutale de la solubilité avec la température.

Les travaux des inventeurs concernant la synthèse de KTP les ont conduits à étudier le processus de cristallisation selon la méthode de synthèse en flux. On rappelle que selon la méthode de synthèse en flux, c'est-à-dire en solutions à température élevée, les constituants du matériau à cristalliser sont dissous dans un solvant et la cristallisation du matériau se produit lorsque la solution devient sursaturée. La sursaturation peut être obtenue par évaporation du solvant, par refroidissement lent de la solution, ou par un processus de transport dans lequel le soluté est transporté d'une région chaude à une autre plus froide. L'intérêt premier de cette méthode réside dans l'obtention des cristaux à une température inférieure au point de fusion du produit si celui-ci est non congruent ou s'il présente des transitions de phase.

Selon un autre aspect intéressant, contrairement à la méthode par croissance hydrothermale, la croissance des cristaux s'effectue dans la pratique avec moins de contraintes mécaniques et de contraintes thermiques.

Diverses difficultés sont rencontrées cependant dans ce type de cristallisation. Il s'agit de difficultés techniques liées à la qualité des fours employés, à la régulation de la température, au choix des lois de refroidissement. D'autres difficultés sont propres au processus de cristallisation dont les conditions ne peuvent être déterminées actuellement de manière satisfaisante avec les méthodes proposées pour établir les courbes de solubilité, connaître les températures de cristallisation et les équilibres chimiques dans le creuset.

L'étude de ce problème par les inventeurs les a conduits à mettre au point une nouvelle méthode leur permettant de suivre l'évolution de la concentration des réactifs au cours de la cristallisation. Sur la base des résultats obtenus, les inventeurs ont constaté qu'en dissolvant les oxydes métalliques ou les sels de départ, mis en oeuvre selon des concentrations définies, un solvant déterminé, puis en refroidissant selon un processus donné, il est possible d'améliorer la qualité des cristaux obtenus et d'empêcher la formation de composés parasites tels que KTi2(PO4)3.

L'invention a donc pour but de fournir un nouveau procédé de synthèse de cristaux du type KTP, exploitable à l'échelle industrielle et conduisant à des cristaux de transparence élevée, particulièrement appropriés à des applications en optique.

Le procédé de synthèse selon l'invention, qui comprend la mise en oeuvre, dans un creuset introduit dans un four, d'un mélange d'oxyde de titane et des oxydes, précurseurs d'oxydes ou des sels des constituants du composé recherché ou de composés du type KTP, préalablement préparés, est caractérisé en ce que :

1 - on ajoute audit mélange ou composé un halogénure du métal alcalin à introduire dans le cristal en une quantité en poids différente de 5 % par rapport au poids de flux lorsque le flux est formé par $K_6P_4O_{13}$,

2 - on chauffe à une température de palier ayant une valeur de 1100 à 650°C environ,

3 - on refroidit le creuset jusqu'à une température voisine de l'ambiante, à une vitesse inférieure à 50°C/h environ et,

4 - on sépare à partir du matériau vitreux formé durant ce procédé, les cristaux du type KTP.

D'une manière avantageuse, les halogénures permettent de limiter le nombre d'éléments étrangers susceptibles de s'incorporer aux cristaux et d'altérer la qualité des propriétés optiques souhaitées. Ils permettent également d'obtenir une solution de faible viscosité à basse température ce qui autorise une vitesse de croissance satisfaisante à basse température. De préférence on utilise une température de palier de 600 à 800°C environ.

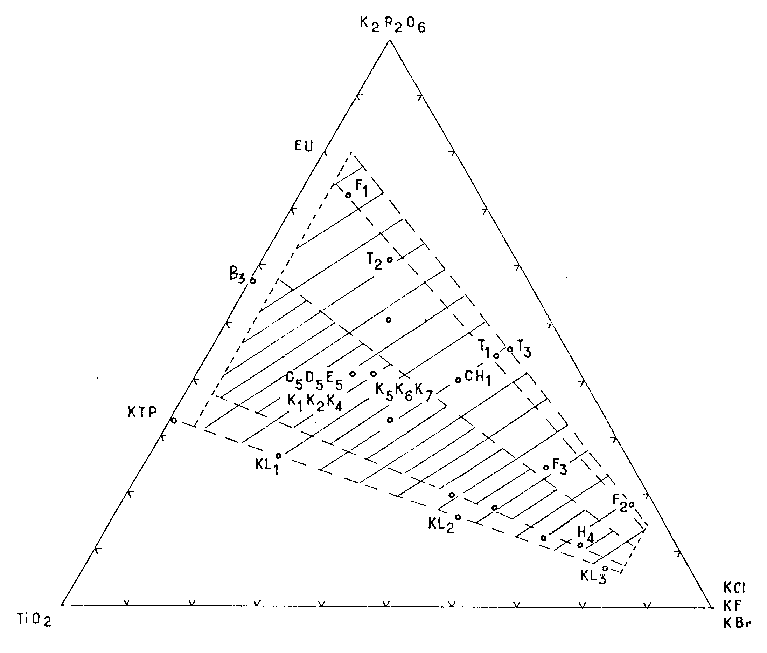

Selon une disposition préférée de l'invention, la composition du mélange mis en oeuvre dans le procédé est choisie dans le diagramme ternaire $TiO_2$, $K_2P_2O_6$, KX, représenté sur la figure unique, avec X représentant F, Cl ou Br, K désignant le potassium, le rubidium ou un mélange de ces deux éléments.

Cette composition correspond au système x-(KTP) + (1-x)KX c'est-à-dire, en se reportant au diagramme en question, à la ligne KTP-KX. Dans ce système x est compris entre environ 0,95 et 0,16.

Pour augmenter la solubilité de KTP dans le système, on ajoute un excès de $K_2P_2O_6$. Le système résultant répond à la formule :

$$u(KTP) + y\,K_2P_2O_6 + z\,KX \text{ avec } \frac{3}{2} + y + z = 1$$

y et z étant les fractions molaires de $K_2P_2O_6$ et KX.

L'excès y de $K_2P_2O_6$ varie typiquement dans le domaine de 0 à 0,725 et de préférence entre 0,1 et 0,60 et z variant de 0,05 à 0,83 et, de préférence, entre 0,05 et 0,60.

La température de début de cristallisation est à la fois fonction de y et de z. Une faible température de début de cristallisation (voisine de 700°C) peut être obtenue avec un faible excès de KCl et une forte valeur de y ou avec un faible excès de $K_2P_2O_6$, mais une forte valeur de z. (voir zone F1, F2 du diagramme).

Selon une disposition supplémentaire, l'excès de $K_2O$ par rapport à $P_2O_5$ varie avantageusement, en fraction molaire, de 1 à 2 environ.

Selon un autre mode de réalisation de l'invention, la cristallisation est effectuée par évaporation isotherme de l'halogénure avec établissement avantageusement d'un gradient thermique.

Dans un autre mode de réalisation de l'invention, la croissance des cristaux est effectuée en ayant recours à la fois à une évaporation isotherme et à un refroidissement lent avec un gradient thermique dans le creuset.

La vitesse de refroidissement est avantageusement de l'ordre de 0,1°C/h à 5°C/h de la température de palier jusqu'à 600°C environ, puis jusqu'à la température ambiante à une vitesse de 50°C/h au plus environ, notamment de l'ordre de 10 à 20°C/h, ce qui permet d'éviter la fracture des cristaux due aux contraintes du verre.

Selon une disposition supplémentaire, l'étape de cristallisation est effectuée avec agitation du mélange. Des résultats satisfaisants sont obtenus avec des vitesses de rotation alternée du creuset de 0 à 350 tours/min.

Selon un mode préféré de réalisation de l'invention, le mélange de poudre de départ est introduit dans un creuset en un matériau inerte vis-à-vis des réactifs, en particulier, en métal précieux, notamment en platine.

Afin d'obtenir un remplissage maximum du creuset, l'introduction du mélange est effectuée en plusieurs étapes et comprend une opération de déshydratation suivie d'une opération de densification.

La déshydratation est effectuée plus spécialement à des températures de l'ordre de 300°C et la densification à des températures d'environ 800°C

Le creuset est ensuite introduit dans un four réglé et programmé en température et qui est porté à la température choisie pour le palier, située entre 1100 et 600°C environ.

Le palier est maintenu pendant 25 à 150 h environ, le creuset étant avantageusement soumis à agitation, avec une vitesse de rotation variable dans le temps de 0 à 300 tours/mn.

Le four est ramené à une température de 600 à 750°C à raison de 0,1 à 5°C/h, puis refroidi jusqu'à l'ambiante à une vitesse inférieure à 50°C/h, avantageusement de l'ordre de 10 à 20°C/h.

Les cristaux obtenus sont récupérés en dissolvant le flux dans de l'eau chaude.

Selon une autre variante de mise en oeuvre, un germe est introduit après homogénéisation de la solution, dans la partie haute du creuset placée dans un gradient thermique variant de 1 à 10°C/cm environ.

Le cristal est extrait après plusieurs centaines d'heures.

La mise en oeuvre de ces dispositions dans des expériences de synthèse de KTP dans des creusets de 70mm de diamètre et de 140mm de hauteur permet d'obtenir des rendements de cristallisation atteignant 75% par rapport à l'oxyde de titane, avec développement de cristaux pouvant atteindre 3 cm3.

Des expériences similaires dans des creusets de plus petite dimension (par exemple de l'ordre de 15mm de diamètre et de 50mm de hauteur) conduisent à des cristaux de plusieurs millimètres de côté, de transparence élevée en particulier lorsqu'on utilise KF.

La mise en oeuvre des dispositions ci-dessus permet d'obtenir avec un rendement élevé des cristaux de KTP ou d'isotypes de grande pureté et de mettre ainsi à profit les propriétés optiques de ces cristaux notamment pour le doublage de fréquence et en électro-optique comme amplificateur parametrique oscillateur ou modulateur comme décrit dans le brevet U.S. 3949323.

Actuellement trois matériaux sont principalement utilisés pour le doublage de fréquence: KDP, $LiNbO_3$, BNN. Ces matériaux ne présentent pas toutes les qualités requises, à savoir: forte non linéarité, excellente tenue en puissance, bonne qualité optique, facilité de fonctionnement. Il apparaît que KTP possède toutes les propriétés, en particulier il est non photoréfractif et peut donc être soumis à de fortes puissances sans que les indices de réfraction soient modifiés.

KTP étant transparent dans le domaine de longueur d'onde 0,35 $\mu$m, 4,5 $\mu$m, on l'utilise avec avantage comme doubleur de fréquence pour les longueurs d'onde supérieurs à 0,9 $\mu$m et en particulier pour doubler les lasers YAG. Nd. permettant ainsi de convertir 1,064 $\mu$m en 0,532 $\mu$m, longueur d'onde visible proche des raies principales du laser Argon. Le rendement de doublage est de 50% environ.

L'association YAG. Nd - KTP présente l'avantage de constituer une alternative aux lasers à gaz rares.

Une telle source présente des avantages sur le plan de la compacité et de la fiabilité.

Il est possible d'envisager de remplacer les lasers à faible puissance tels que le laser He-Ne pour les applications en recherche et métrologie. Ceci implique la possibilité de réaliser le doublage dans une couche mince de cristal non linéaire.

En outre, pour les applications médicales, il est intéressant de disposer d'un système à deux longueurs d'onde, l'une dans l'infrarouge, l'autre dans le visible.

Les dispositions qui précèdent s'appliquent avantageusement à la synthèse de RbTP en utilisant de l'halogénure de Rb et aux différents termes de la solution solide $K_a Rb_{(1-a)}$ TP avec $0 \leq a \leq 1$.

Les fractions atomiques de K et de Rb dans les cristaux obtenus dépendent des concentrations en $K_2 P_2 O_6$ et $Rb_2 P_2 O_6$ ainsi que des concentrations en KX et RbX.

Pour illustrer l'invention, on rapporte ci-après des exemples relatifs à la synthèse de cristaux de KTP. (exemples 1 à 8) et de RbTP-KTP (exemples 9 et 10).

Les produits de départ utilisés dans les expériences décrites correspondent aux produits suivants commercialisés par Merck :

| | |
|---|---|
| -$TiO_2$ | oxyde de titane (réf. 808) |
| -$KH_2 PO_4$ | dihydrogénophosphate de potassium pour analyse (réf. 4873) |
| -$K_2 HPO_4$ | hydrogéno-phosphate de dipotassium pour analyse (réf. 5104) |
| -KCl | chlorure de potassium pour analyse (réf. 4936) |
| -KF | fluorure de potassium pour analyse (réf. 4994) |
| -KBr | (réf. 4904) |
| -RbCl | (réf. 7622) |
| -RbOH | Veutron (réf. 16608) |
| -$NH_4 H_2 PO_4$ | Prolabo (réf.2130529) |

Comme creusets, on utilise des creusets en platine pur de la Compagnie des métaux précieux.

Sur le diagramme de la figure unique, on a représenté les expériences réalisées. La zone hachurée correspond au domaine étendu de cristallisation de KTP dans le système $TiO_2$,KX, $K_2 P_2 O_6$ avecX représentant Cl, F ou Br.

Dans la zone simplement hachurée limitée par F1, T3, F2, F3, B3, les températures de cristallisation diminuent jusqu'à 600°C (T3). La croissance par germination spontanée ne conduit qu'à de petits cristaux, l'évaporation devient faible ou nulle. (en dessous de 850°C pour KF et de 750°C pour KCl et KBr). Le rendement de cristallisation devient faible en allant vers F1, F2. Par conséquent, cette zone est particulièrement adaptée à une croissance par transport sur germe. Ce dernier est alors introduit à la partie supérieure du bain plus froide que le fond du creuset (gradient de 1 à 10°C/cm) en utilisant une réserve de fond de creuset. Les vitesses de croissance du germe varient (de 0,01 nm/s à 10 nm/s) selon la composition, la température de palier et le gradient thermique dans le creuset. Les essais effectués ont permis de démontrer que la vitesse linéaire est constante. Des cristaux de 3cm³ ont ainsi été obtenus.

La ligne KTP-KCl correspond à la dissolution de KTP dans l'halogénure. Les expériences KL1,KL2,KL3 (voir exemple 5 ci-après) montrent que KTP est peu soluble dans KCl, ce qui contraint à travailler à haute température. 1020°C pour KL1 et KL2, 900°C pour KL3.

Le domaine de composition le mieux adapté à la croissance de cristaux de KTP par germination spontanée sans formation de composés parasites, correspond à la zone doublement hachurée. Les températures maximales varient de 1050°C à 900°C.

Le contrôle du processus de croissance par refroidissement lent et surtout par évaporation est délicat, les températures élevées de cristallisation induisent une forte probabilité d'incorporation des impuretés ou des difficultés techniques importantes.

Le rendement de cristallisation est important et l'on évite la formation de composés parasites tels que le rutile pour les hautes températures dans les mélanges proches de KTP et la formation de $KTi_2$-$(PO_4)_3$ pour les mélanges proches de l'eutectique (EU).

Quelques expériences faites dans le diagramme $TiO_2$-$K_4P_2O_7$-KCl conduisent à des cristaux de KTP mais, la solubilité molaire de KTP dans $K_4P_2O_7$ est plus faible à une température donnée que dans $K_2P_2O_6$ et par suite, à fortiori, la solubilité massique et le rendement de cristallisation.

EXEMPLE 1 : Synthèse de cristaux de KTP (expérience H4)

Dans un creuset ouvert de platine de 15 mm de diamètre et de 45 mm de hauteur, on introduit le mélange de départ suivant :
2,85g $KH_2PO_4$ + 1,21g $TiO_2$ + 5,04gKCl.
L'introduction du mélange est effectuée en plusieurs étapes pour obtenir un remplissage optimum du creuset.

Une partie du mélange est déshydratée à 250°C puis densifiée à 800°C. Le creuset est alors rechargé avec une autre partie du mélange et à nouveau déshydraté et densifié jusqu'à l'obtention du remplissage du creuset.

Le creuset partiellement fermé ou non par une mince feuille de platine est introduit dans le four. On utilise un four régulé et programmé en température et muni d'un dispositif d'agitation du creuset par rotation accélérée comme décrit par Elwell et al dans Academic Press, 1975.

Le four est porté en quelques heures à 1100°C. Ce palier de température est maintenu 96 heures. La vitesse de rotation de l'agitation du creuset varie de 0 à 200 t/mn en 3 mn environ puis est décélérée de la même manière et inversée. La vitesse initiale d'évaporation de l'halogénure est de l'ordre de 0,1g/cm²/h.

Le four est refroidi ensuite à 5°C/h jusqu'à 560°C puis à 15°C/h jusqu'à l'ambiante.

La pesée du creuset après expérience indique que KCl est presque entièrement évaporé.

Les cristaux sont extraits par dissolution du verre dans l'eau chaude. On distingue très nettement deux familles de cristaux. L'une de "gros cristaux" transparents de 2 à 3 mm de côté provenant de la croissance par évaporation, l'autre formée de très petit cristaux de 0,1mm de côté provenant du refroidissement lent.

EXEMPLE 2 : (expérience C5)

On opère comme dans l'exemple 1 mais en utilisant le mélange de poudre suivant :
9,53g $KH_2PO_4$ + 2,39g $TiO_2$ + 1,51g KCl

Le creuset est fermé par une feuille de platine introduit dans le four et porté à 1110°C pendant 70 h. La vitesse de refroidissement est de 1,5°C/h jusqu'à 750°C suivi d'un refroidissement jusqu'à l'ambiante à 20°C/h.

On obtient dans le tiers supérieur du creuset des cristaux transparents de KTP de 4 à 6 mm de côté et dans le fond du creuset, une grande quantité de petits cristaux (0,1mm).

Une expérience identique à C5 mais avec un creuset de 35 mm de diamètre et de hauteur 50 mm et un mélange initial 5 fois plus important conduit à des cristaux de KTP transparents de dimensions maxima 10x5x5mm. Le rendement massique global en KTP est de 30% (expèrience D5).

EXEMPLE 3 : (expériences K1,K2,K4)

On opère comme dans l'exemple 1 en remplaçant KCl par KF (expérience K1) et par KBr (expérience K4). On utilise KCl dans l'expérience K2.

Les mélanges de départ sont respectivement les suivants:

K1 9,53g $KH_2PO_4$ + 2,39g $TiO_2$ + 1,19 g KF
K2 9,53g $KH_2PO_4$ + 2,39g $TiO_2$ + 1,52 g KCl K4 9,53g $KH_2PO_4$ + 2,39g $TiO_2$ + 2,4.g KBr.

Les plus beaux cristaux atteignant 4 à 5mm sont obtenus dans l'expérience K1.

EXEMPLE 4 :(expériences K5,K6,K7).

Les expériences K5,K6,K7 réalisées correspondent aux précédentes en creuset ouvert pour une dilution un peu plus forte de $TiO_2$. La température maximum est de 1020°C pendant 100 h puis on refroidit à 2°C/h jusqu'à 620°C et à 15°C/h jusqu'à l'ambiante.

Les compositions des mélanges de départ sont les suivantes :

$K_5$ : 9,8g $KH_2PO_4$ + 2,2g $TiO_2$ + 1,77 g KCl
$K_5$ : 9,8g $KH_2PO_4$ + 2,2g $TiO_2$ + 1,38 g KF
$K_7$ : 9,8g $KH_2PO_4$ + 2,2g $TiO_2$ + 2,64 g KBr

On obtient des cristaux de plusieurs millimètres très limpides dans les 3 creusets.

EXEMPLE 5 : (expérience KL1)

On opère dans les mêmes conditions que pour $K_5$, $K_5$, $K_7$, avec le mélange suivant :

9,8g $KH_2PO_4$ + 5,59 g $TiO_2$ + 1,05 g KF + 0,91g KCl.

En variante le mélange initial est :

10,67g KTP + 1,05g KF + 0,91g KCl

On obtient des petits cristaux transparents en plus de la présence de quelques cristaux de rutile.

EXEMPLE 6 : (expérience E5)

On opère en creuset fermé de diamètre 60mm et de hauteur 60 mm dans des conditions voisines de celles rapportées dans l'exemple 2 mais avec une charge totale de 400 g au lieu de 13,4 g dans l'exemple 2. On obtient des cristaux de 10x10x17mm.

EXEMPLE 7 :

On effectue une expérience dans le diagramme $K_4P_2O_7$ - $TiO_2$ - KCl dans les mêmes conditions que dans l'exemple 2 avec un mélange initial de composition:

10,45g $KH_2PO_4$ + 4,79g $TiO_2$ + 5,22g KCl. On obtient des cristaux transparents de 2 à 3 mm. de côté.

EXEMPLE 8 :

Synthèse de cristaux de KTP avec utilisation de germe. (expérience CH1).

Dans un creuset de 60 mm de diamètre et de 70 mm de hauteur, on introduit :225,80g $KH_2PO_4$ + 32,40g $TiO_2$ + 80,90g KCl.

On porte le four à une température de 1000°C, qu'on maintient durant 150 h. Le gradient est de 2°C/cm puis on introduit le germe. On refroidit à une vitesse de 1°C/h jusqu'à 700°C puis à 20°C/h jusqu à l'ambiante.

L'évaporation moyenne en halogènure est de 38g.

On obtient 40g de cristaux de KTP avec un cristal de 3cm$^3$ poussé sur le germe.

Dans une autre expérience de ce type (expérience T1), on opère dans un creuset de 25 mm de diamètre et 60 mm de hauteur en utilisant le mélange initial suivant : 40,27g $KH_2PO_4$ + 3,0g $TiO_2$ + 11,18g KCl.

On utilise une température de palier de 640°C, un gradient de 3°C/cm. Après 120 h, on introduit un germe de 200 mg. La vitesse linéaire de croissance est de 0,5 nm/s. En phase finale, le cristal extrait présente des faces {100} de 5 mm de largeur au lieu de 0,1 mm initialement.

Plusieurs expériences de ce type : T2 et T3 menées respectivement à 740°C et 600°C dans des gradients atteignant 10°C/cm ont permis de faire varier la vitesse linéaire de croissance de 0,01 nm/s à 4 nm/s et de montrer que la morphologie finale du cristal dépend des conditions de croissance et de la qualité du germe introduit.

EXEMPLE 9 :

Synthèse de cristaux de $K_a Rb_{1-a}TP$ (expérience KR5) o $\leq$ a $\leq$ |.

Dans un creuset de platine de 25 mm de diamètre et 60 mm de hauteur, on introduit le mélange initial suivant :

16,3 g $KH_2PO_4$ + 12,3g RbOH + 7,99 g $TiO_2$ + 13,8 g $NH_4H_2PO_4$ + 4,47 g KCl + 7,255g RbCl

Le four est porté à 869°C et cette température maintenue pendant 50 heures. On effectue un refroidissement lent à 2°C/h jusqu'à 550°C puis à 20°C/h jusqu'à l'ambiante.

On obtient des cristaux limpides de 5 à 6 mm de côté, de composition a = 0,6. Les compositions a = 0,21 et a = 0,77 ont également été préparées.

EXEMPLE 10 :

Synthèse de cristaux de RbTP

En opérant selon les conditions de l'exemple 9, on obtient des cristaux présentant jusqu'à 10 mm de côté.

Etude et caractérisation des cristaux de KTP et de $K_aRb_{(1-a)}TP$.

Leur identification a été faite aux rayons X, par la méthode du cristal tournant et de Laue, et par microsonde électronique de Castaing.

L'étude au goniomètre optique indique que la morphologie des cristaux millimétriques est presque toujours constituée des formes suivantes (analogues à celles décrites par BIERLEIN et al dans le brevet US 3 949 323)

- pinacoïde {100}
- prisme {210}
- dièdres {201} 1,2
- dièdres {011} 1,2

L 'étude morphologique montre que selon le processus de croissance utilisé, selon la composition initiale de la solution et selon la température de cristallisation, il est possible de modifier les vitesses relatives de croissance des faces. Par exemple, celles des faces (100) (201), (101), ce qui facilite l'orientation des cristaux et permet une taille plus aisée et plus efficace.

L'étude des diagrammes d'équilibre montre que le coefficient de partage du K et du Rb, entre la phase liquide et la phase solide, reste proche de 1 pour toute composition de solution solide $K_a Rb_{1-a}TP$.

L'analyse des traces par spectrométrie laser (LAMMA) montre que les impuretés dépendent directement de la pureté des produits initiaux mais aussi de la température de cristallisation et de la vitesse de croissance. L'halogène présent en élément majeur dans la solution, se retrouve en trace dans les cristaux (de 100 à 1000 ppm), en quantité comparable aux $OH^-$ alors que dans les procédés de synthèse par croissance hydrothermale, la quantité d'$OH^-$ est plus élevée.

Les études de topographie X et de largeur de raies de diffraction au rayonnement synchrotron, mettent en évidence une grande perfection cristalline. La désorientation étant inférieure à 27" d'arc.

L'étude sur poudre de KTP, RbTP et de plusieurs termes de la solution solide $K_a Rb_{1-a}TP$, de la température de disparition du faisceau doublé confirme l'existence d'une température de transition cristallographique à haute température pour KTP (936°C) et RbTP (800°C) mise en évidence par YANOVSKII et al. V.K. Physics Statu Solidi (A) Vol 93 p 665-688 1986. On montre que cette température de transition varie proportionellement à la composition.

La tenue en puissance est qualitativement comparable à celle indiquée notamment par Zumsteg et al dans J.Appl.Phys. 47 (1976) et Yao et al dans J.Appl.Phys. 55, (1984)65.

Ces résultats mettent en évidence l'intérêt des méthodes de croissance de cristaux KTP et isotypes à des températures significativement inférieures à 800°C.

Plusieurs cristaux de KTP ont été taillés pour le doublage de fréquence (1,06 $\mu$m 0,53 $\mu$m) de type II (theta = 0,phi = 26°). La longueur utile maximum est de 5 mm. La mesure de la largeur thermique de phase matching est de 15 deg. cm. Tous les cristaux testés présentent une variation thermique de l'intensité doublée caractéristique des cristaux de bonne qualité.

**Revendications**

1. Procédé de synthèse de cristaux du type $KTiOPO_4$ (KTP) comprenant la mise en oeuvre, dans un creuset introduit dans un four d'un mélange d'oxyde de titane et des oxydes, précurseurs d'oxydes ou des sels des constituants du composé recherché, ou de composés du type KTP préalablement préparés, caractérisé en ce que :

   1 - on ajoute audit mélange ou composé un halogénure du métal alcalin à introduire dans le cristal en une quantité en poids différente de 5 % par rapport au poids de flux lorsque le flux est formé par $K_6 P_4 O_{13}$,

   2 - on chauffe à une température de palier ayant une valeur de 1100 à 650°C environ,

   3 - on refroidit le creuset jusqu'à une température voisine de l'ambiante, à une vitesse inférieure à 50°C/h environ et,

   4 - on sépare à partir du matériau vitreux formé durant ce procédé, les cristaux du type KTP.

2. Procédé selon la revendication 1, caractérisé en ce que l'étape 2 conduit à la formation de KTP en tant que soluté et d'un solvant composé de $K_2 P_2 O_6$ et KX, X représentant F, Cl ou Br, K désignant le potassium, le rubidium ou un mélange de ces deux éléments.

3. Procédé selon la revendication 1 ou 2, caractérisé en ce que la composition du mélange mis en oeuvre est choisie dans le diagramme ternaire TiO2, $K_2 P_2 O_6$, KX, X représentant F, Cl ou Br.

4. Procédé selon la revendication 3, caractérisé en ce que la composition de flux conduit à la formation de KTP en tant que soluté et de KX en tant que solvant selon la formule x(KTP) + (1-x)KX, x étant la fraction molaire de KTP et étant compris entre environ 0,95 et 0,16.

5. Procédé selon la revendication 4, caractérisé en ce qu'on ajoute un excès de $K_2 P_2 O_6$, ce qui correspond aprés réaction á un système de formule : u(KTP) + y($K_2 P_2 O_6$) + z (KX) avec $3\frac{u}{2}$ + y + z = 1, y et z étant les fractions molaires de $K_2 P_2 O_6$ et de KX, l'excès y de $K_2 P_2 O_6$ variant typiquement dans le domaine de 0 à 0,725 et de préférence entre 0,10 et 0,60 et z variant de 0,05 à 0,83 et, de préférence, entre 0,05 et 0,60.

6. Procédé selon la revendication 3, caractérisé en ce que l'excès de $K_2 O$ par rapport à $P_2 O_5$ varie en fraction molaire de 1 à 2 environ.

7. Procédé selon l'une quelconque des revendications 1 à 6, caractérisé en ce qu'on effectue la cristallisation par évaporation isotherme de l'halogénure, la vitesse d'évaporation initiale étant de 0,1g/$cm^2$/h environ.

8. Procédé selon l'une quelconque des revendications 1 à 7, caractérisé en ce qu'on a recours, en outre, à un processus de refroidissement lent et/ou à un gradient thermique dans le creuset de l'ordre de 1°C/cm à 10°C/cm.

**9.** Procédé selon la revendication 7 ou 8, caractérisé en ce que l'on introduit un germe après homogénéisation de la solution.

**10.** Procédé selon la revendication 8 ou 9, caractérisé en ce que la vitesse de refroidissement est de l'ordre de 0,1 à 5°C/h depuis la température de palier jusqu'à 600°C environ, puis jusqu'à la température ambiante, à une vitesse de 50°C/h au plus environ, notamment, de l'ordre de 10 à 20°C/h.

**11.** Procédé selon la revendication 1, caractérisé en ce que le composé de type KTP répond à la formule $K_aRb_{1-a}TiPO_4$ avec $0 \leq a \leq 1$ et l'halogénure est KCl et RbCl.

**12.** Procédé selon la revendication 1, caractérisé en ce que le composé de type KTP est RbTP et l'halogénure est RbCl.

**13.** Produits, ayant la composition correspondant à la formule $x(KTiOPO_4) + (1-x) KX$ où X représente F, Cl ou Br, x est la fraction molaire de KTP avec x compris entre environ 0,95 et 0,16, ou encore à la formule $u(KTiOPO_4) + y(K_2P_2O_6) + z (KX)$ avec $\frac{3}{2} u + y + z = 1$, u y et z représentant les proportions molaires respectives des composés $KTiOPO_4$, $K_2P_2O_6$ et KX, X représentant F, Cl ou Br, y variant dans le domaine de 0 à 0,725 et z variant de 0,05 à 0,83, K représentant le potassium, le rubidium ou un mélange de ces deux éléments.

**14.** Produits selon la revendication 13, caractérisés en ce que y varie dans le domaine de 0,10 à 0,60 et z de 0,05 à 0,60.

## Claims

**1.** A process for synthesising crystals of $KTiOPO_4$ (KTP) comprising the use, in a crucible introduced into a furnace, of a mixture of titanium oxide and oxides, precursors of oxides or salts of the constituents of the required compound, or previously prepared compounds of KTP type, characterized by:

1 - introducing into said mixture or compound a halide of the alkaline metal to be introduced into the crystal in a quantity differing by 5% in weight with respect to the weight of flux when the flux is formed by $K_6P_4O_{13}$,

2 - heating to a temperature plateau of approximately 1100 to 650°C,

3 - cooling the crucible to a temperature close to ambient temperature at a speed lower than approximately 50°C/h, and

4 - separating the KTP type crystals from the vitreous materials formed during the process.

**2.** A process according to Claim 1, characterized in that stage 2 leads to the formation of KTP as solute and a solvent made up of $K_2P_2O_6$ and KX, where X denotes F, Cl or Br, K denotes potassium, rubidium or a mixture of these two elements.

**3.** A process according to Claims 1 or 2, characterized in that the composition of the mixture used is selected from the ternary diagram $TiO_2$, $K_2P_2O_6$, KX, where X denotes F; Cl or Br.

**4.** A process according to Claim 3, characterized in that the composition of flux leads to the formation of KTP as solute and of KX as solvent in accordance with the formula $x(KTP) + (1-x)KX$, where x is the molar fraction of KTP and lies between approximately 0.95 and 0.16.

**5.** A process according to Claim 4, characterized in that an excess of $K_2P_2O_6$ is added, this corresponding after reaction to a system having the formula: $u(KTP) = y(K_2P_2O_6) + z (KX)$ with $\frac{3}{2} u + y + z = 1$, where y and z are the molar fractions of $K_2P_2O_6$ and KX, the excess y of $K_2P_2O_6$ typically varying in the range from 0 to 0.725 and preferably between 0.10 and 0.60, and z varying between 0.05 and 0.83 and preferably between 0.05 and 0.60.

**6.** A process according to Claim 3, characterized in that the excess of $K_2O$ with respect to $P_2O_5$ varies in molar fraction from approximately 1 to 2.

**7.** A process according to any of Claims 1 to 6, characterized in that crystallisation is performed by the isothermal evaporation of the halide, the initial evaporation speed being approximately $0.1g/cm^2/h$.

**8.** A process according to any of Claims 1 to 7, characterized in that it includes a cooling process which is slow and/or has a thermal gradient in the crucible of the order of 1°C/cm to 10°C/cm.

**9.** A process according to Claim 7 or 8, characterized in that a seed is introduced after the homogenisation of the solution.

**10.** A process according to Claim 8 or 9, characterized in that the cooling speed is of the order of 0.1 to 5°C/h from the temperature plateau to approximately 600°C then to ambient temperature to approximately 50°C/h at most, more particularly of the order of 10 to 20°C/h.

11. A process according to Claim 1, characterized in that the KTP compound has the formula $K_aRb_{1-a}TiPO_4$ with $o \leq a \leq 1$ and the halide is KCl and RbCl.

12. A process according to Claim 1, characterized in that the KTP compound is RbTP and the halide is RbCl.

13. Products, having the composition corresponding to the formula $x(KTiOPO_4) + (1-x) KX$, wherein X represents F, Cl or Br, $\underline{x}$ is the molar fraction of KTP, with x being comprised between approximately $0.95$ and 0.16, or to the formula $u(KTiOPO_4) + y(K_2P_2O_6) + z (KX)$ with $\frac{3}{2} u + y + z = 1$, u, y and z representing the molar proportions of $KTiOPO_4$, $K_2P_2O_6$ and KX, respectively, X representing F, Cl or Br, y varying in the range of 0 to 0.725 and z varying from 0.05 to 0.83, K representing potassium, rubidium or a mixture of the two elements.

14. Products according to claim 13, wherein y varies in the range of 0.10 to 0.60 and z of 0.05 to 0.60.

**Patentansprüche**

1. Verfahren zur Synthese von Kristallen vom Typ $KTiOPO_4$ (KTP), welches Verfahren den Einsatz eines Gemisches aus Titanoxid und Oxiden, Oxidvorläufern oder Salzen der Bestandteile der gewünschten Verbindung oder von zuvor hergestellten Verbindungen vom Typ KTP in einem in einen Ofen eingebrachten Tiegel umfaßt, dadurch gekennzeichnet, daß man:
   1 - dem genannten Gemisch oder der genannten Verbindung ein Halogenid des in den Kristall einzubringenden Alkalimetalls in einer Gewichtsmenge zusetzt, die sich um 5 %, bezogen auf das Gewicht der Schmelze, wenn die Schmelze aus $K_6P_4O_{13}$ gebildet ist, unterscheidet,
   2 - auf eine Ausgangstemperatur mit einem Wert von ungefähr 1.100 bis 650°C erhitzt,
   3 - den Tiegel bis auf eine Temperatur nahe der Umgebungstemperatur mit einer Geschwindigkeit von unter etwa 50°C/h abkühlt und

4 - die Kristalle von Typ KTP aus dem während dieses Vorganges gebildeten glasigen Material abtrennt.

2. Verfahren nach Anspruch 1, dadurch gekennzeichnet, daß die Stufe 2 zur Ausbildung von KTP in Form eines gelösten Stoffes und eines Lösungsmittels, bestehend aus $K_2P_2O_6$ und KX, führt, wobei X für F, Cl oder Br steht und K Kalium, Rubidium oder ein Gemisch dieser beiden Elemente bezeichnet.

3. Verfahren nach Anspruch 1 oder 2, dadurch gekennzeichnet, daß die Zusammensetzung des eingesetzten Gemisches aus dem ternären Diagramm $TiO_2$, $K_2P_2O_6$ und KX gewählt wird, wobei X für F, Cl oder Br steht.

4. Verfahren nach Anspruch 3, dadurch gekennzeichnet, daß die Zusammensetzung der Schmelze zur Ausbildung von KTP in Form eines gelösten Stoffes und von KX in Form von Lösungsmittel entsprechend der Formel x-(KTP) + (1-x)KX führt, worin x die Molfraktion von KTP bezeichnet und zwischen etwa 0,95 und 0,16 beträgt.

5. Verfahren nach Anspruch 4, dadurch gekennzeichnet, daß man einen Überschuß an $K_2P_2O_6$ zusetzt, was nach der Reaktion einem System der Formel: $u(KTP) + y(K_2P_2O_6) + z (KX)$ entspricht, mit $\frac{3}{2} u + y + z = 1$, wobei y und z die Molfraktionen von $K_2P_2O_6$ und von KX sind und wobei der Überschuß y von $K_2P_2O_6$ typischerweise im Bereich von 0 bis 0,725 liegt und vorzugsweise zwischen 0,10 und 0,60 liegt und z von 0,05 bis 0,83 und vorzugsweise zwischen 0,05 und 0,60 variiert.

6. Verfahren nach Anspruch 3, dadurch gekennzeichnet, daß der Überschuß von $K_2O$ gegenüber $P_2O_5$ in Molfraktion von ungefähr 1 bis 2 variiert.

7. Verfahren nach einem der Ansprüche 1 bis 6, dadurch gekennzeichnet, daß man die Kristallisation durch isotherme Verdampfung des Halogenids bewirkt, wobei die Anfangsverdampfungsgeschwindigkeit ungefähr $0,1$ g/cm$^2$/h beträgt.

8. Verfahren nach einem der Ansprüche 1 bis 7, dadurch gekennzeichnet, daß man zusätzlich einen langsamen Abkühlungsvorgang und/oder einen thermischen Gradienten im Tiegel in der Größenordnung von 1°C/cm bis 10°C/cm vorsieht.

**9.** Verfahren nach Anspruch 7 oder 8, dadurch gekennzeichnet, daß man nach der Homogenisierung der Lösung einen Keim einführt.

**10.** Verfahren nach Anspruch 8 oder 9, dadurch gekennzeichnet, daß die Abkühlungsgeschwindigkeit von der Ausgangstemperatur bis auf etwa 600°C in der Größenordnung von 0,1 bis 5°C/h beträgt und dann bis auf die Umgebungstemperatur eine Abkühlungsgeschwindigkeit von höchstens etwa 50°C/h, insbesondere in der Größenordnung von 10 bis 20°C/h, eingehalten wird.

**11.** Verfahren nach Anspruch 1, dadurch gekennzeichnet, daß die Verbindung vom Typ KTP der Formel $K_aRb_{1-a}TiPO_4$ entspricht, mit $0 \leq a \leq 1$, und das Halogenid KCl und RbCl ist.

**12.** Verfahren nach Anspruch 1, dadurch gekennzeichnet, daß die Verbindung vom Typ KTP RbTP ist und das Halogenid RbCl ist.

**13.** Produkte mit einer Zusammensetzung entsprechend der Formel

$$x(KTiOPO_4) + (1-x) KX,$$

worin X für F, Cl oder Br steht, x die Molfraktion von KTP bezeichnet und zwischen etwa 0,95 und 0,16 beträgt, oder auch entsprechend der Formel $u(KTiOPO_4) + y(K_2P_2O_6) + z(KX)$, mit $\frac{3}{2} u + y + z = 1$,
wobei u, y bzw. z die Molverhältnisse der Verbindungen $KTiOPO_4$, $K_2P_2O_6$ bzw. KX darstellen, X für F, Cl oder Br steht, y im Bereich von 0 bis 0,725 variiert und z im Bereich von 0,05 bis 0,83 variiert und K für Kalium, Rubidium oder ein Gemisch dieser beiden Elemente steht.

**14.** Produkte nach Anspruch 13, dadurch gekennzeichnet, daß y im Bereich von 0,10 bis 0,60 variiert und z im Bereich von 0,05 bis 0,60 variiert.